# EUROPÄISCHE PATENTSCHRIFT

(11) **EP 0 730 161 B1**
(45) Veröffentlichungstag und Bekanntmachung des Hinweises auf die Patenterteilung: **29.05.2002**
(21) Anmeldenummer: 96100668.1
(22) Anmeldetag: 18.01.1996
(51) Int. Cl.: G01R 31/327

(54) **Verfahren sowie Vorrichtung zur Überprüfung von Schutzmassnahmen in realen IT-Netzen**
Method and device for testing the protection arrangements of a real star-delta network
Procédé et appareil de test des dispositifs de protection d'un réseau Y-delta reél

(30) Priorität: 01.03.1995 DE 19507060
(43) Veröffentlichungstag der Anmeldung: 04.09.1996
(73) Patentinhaber: GOSSEN-METRAWATT Gesellschaft mit beschränkter Haftung, D-90471 Nürnberg (DE)
(72) Erfinder: Schweiger, Raimund, Dr.-Ing., D-92280 Kastl (DE); Ziegler, Herbert, D-90482 Nürnberg (DE)
(74) Vertreter: Hafner, Dieter, Dr.rer.nat., Dipl.-Phys.

(56) Entgegenhaltungen:
- EP-A- 0 368 029
- EP-A- 0 368 030
- BE-A- 647 635
- DE-A- 2 306 621
- DE-B- 1 137 115

## Beschreibung

Die Erfindung betrifft ein Verfahren zur Überprüfung von Schutzmaßnahmen in mit Fehlerstromschutzeinrichtungen ausgestatteten IT-Netzen sowie eine Vorrichtung zur Durchführung dieses Verfahrens.

Im Gegensatz zum TT-Netz bzw. TN-Netz sind die aktiven Teile eines idealen IT-Netzes nicht direkt geerdet. Beim Vorliegen eines Einzelerdschlusses einer Phase des idealen IT-Netzes kann deshalb kein Erdfehlerstrom fließen, da hierzu ein über die Erdung der aktiven Teile des idealen IT-Netzes geschlossener Stromkreis notwendig wäre.

Die für das ideale IT-Netz charakteristische vollständige Isolierung der aktiven Teile gegenüber Erde tritt in der Praxis allerdings nur bei Kleinnetzen mit einer geringen Anzahl von Verbrauchern auf.

Ein reales IT-Netz weist zwar auch keine direkte Erdung der aktiven Netzteile auf, zeichnet sich aber ab einer gewissen Netzgröße zwangsläufig durch auftretende Erdableitströme angeschlossener Verbraucher und durch eine kapazitive Kopplung der Netzphasen gegenüber Erde aus. In derartigen realen IT-Netzen kann also bei einem auftretenden Einzelerdschlußfehler einer Netzphase ein Fehlerstrom fließen, dessen Größe im wesentlichen von der Netzphasenimpedanz gegenüber Erde abhängt. Die Erdung der Phasen im realen IT-Netz gegenüber Erde besitzt im allgemeinen einen relativ hohen Erdungswiderstand, so daß im Fall eines Einzelerdschlusses im allgemeinen deutlich geringere Fehlerströme als in TN-/TT-Netzen auftreten, da bei TN-/TT-Netzen durch die direkte Erdung der aktiven Netzteile relativ niedrige Erdungswiderstände vorgegeben sind, welche das Auftreten eines beträchtlichen Fehlerstroms im Fall eines Einzelerdschlusses ermöglichen.

Da beim realen IT-Netz wie beschrieben Fehlerströme im Falle von Einzelerdschlüssen auftreten können, ist zur umfassenden Absicherung realer IT-Netze der Einsatz von Fehlerstromschutzschaltem notwendig, welche beim Auftreten eines Fehlerstroms (z.B. durch direktes Berühren einer Phase) eine Netzunterbrechung veranlaßt.

Zur Überprüfung derartiger Fehlerstromschutzeinrichtungen in realen IT-Netzen läßt man beispielsweise einen Prüfstrom in Höhe des Nennfehlerstroms der Fehlerstromschutzeinrichtung von einer vor der Fehlerstromschutzeinrichtung liegenden Phase zu einer anderen, nach der Fehlerstromschutzeinrichtung angeordneten Phase fließen, woraufhin eine ordnungsgemäße Auslösung der Fehlerstromschutzeinrichtung erfolgen muß. Hiermit wird zwar die grundsätzliche Funktionsfähigkeit der Fehlerstromschutzeinrichtung ermittelt, es wird jedoch nicht sichergestellt, daß die Fehlerstromschutzeinrichtung beim Vorliegen eines Einzelerdschlußfehlers tatsächlich anspricht.

Eine weitere Möglichkeit der Überprüfung von Fehlerstromschutzeinrichtungen in IT-Netzen besteht darin, daß die zur Überprüfung der Fehlerstromschutzeinrichtung in TN-/TT-Netzen verwendeten Prüfgeräte auch zur Überprüfung der realen IT-Netzes (z.B. Ansprechen der Fehlerstromschutzeinrichtungen, Messung der Höhe des Fehlerstroms und der Berührungsspannung) verwendet werden.

Die Ermittlung der Berührungsspannung erfolgt in diesem Zusammenhang im allgemeinen durch die Erfassung einer Absenkung der Netzspannung, welche beim Fließen eines Fehlerstroms im Falle eines Einzelerdschlusses auftritt. In TN-/TT-Netzen kann durch die Erdung der aktiven Teile die Spannung jeder Phase gegenüber Erde als unveränderlich angesehen werden, so daß über den Betrag der Absenkung der Netzspannung auch tatsächlich der Betrag der Berührungsspannung erfaßt werden kann.

Da aber im realen IT-Netz die einzelnen Netzphasen mit unterschiedlichen Impedanzen geerdet und kapazitiv gekoppelt sind und bei der Netzprüfung das Prüfgerät den (unterschiedlichen) Koppelimpedanzen der einzelnen Phasen parallelgeschaltet wird, erfolgt durch die Netzprüfung einer Veränderung der Phasenkopplung gegen Erde. Somit tritt eine zusätzliche Potentialverlagerung (Netzspannungsabsenkung) gegen Erde auf, welche mit der Netzspannungsabsenkung beim Fließen eines Fehlerstroms aufgrund eines Einzelerdschlusses in keinem quantifizierbaren Zusammenhang steht. Es ist deshalb bei der Überprüfung realer IT-Netze nicht möglich, aus der Absenkung der Netzspannung beim Fließen eines Fehlerstroms Rückschlüsse auf den Betrag der Berührungsspannung zu ziehen.

Diese unkalkulierbare Absenkung der Netzspannung kann durch bewußtes Erzeugen eines Einzelerdschlußfehlers theoretisch verhindert werden, hierdurch würde aber das reale IT-Netz in ein TN-Netz umgewandelt und die ermittelten Meßergebnisse würden in keinem Bezug mehr zum realen IT-Netz stehen.

Die Überprüfung realer IT-Netze durch die von den TN-/TT-Netzen her bekannten Verfahren und Prüfgeräte führt demnach zu irreführenden bzw. unbefriedigenden Meßergebnissen.

Als technologischer Hintergrund auf dem Erfindungsgebiet sind weiterhin bekannt geworden:
EP 0 368 029 "Meßverfahren und Schaltungsanordnung zur Überprüfung von Schutzmaßnahmen in Wechselspannungsnetzen",
EP 0368 030 "Meßverfahren und Schaltungsanordnung zur Ermittlung des Auslösestroms von FI-Schaltern",
DE 23 06 621 "Prüfgerät für Fehlerströmschutzschaltungen",
DE 11 37 115 "Schaltungsanordnung zur Prüfung von Fehlerstrom- und Fehlerspannungsschutzschaltern" sowie
BE 647635 "Verfahren und Vorrichtung zur Überprüfung der Isolation eines elektrischen Wechselspannungsnetzes".

Der Erfindung liegt nun die Aufgabe zugrunde, ein Verfahren zur Überprüfung von Schutzmaßnahmen in mit Fehlerstromschutzeinrichtungen ausgestatteten IT-Netzen anzubieten, welches auf die bei realen IT-Netzen auftretenden Netzzustände zugeschnitten ist und eine fehlerfreie Ermittlung relevanter Meßgrößen (wie Berührungsspannung, Fehlerstrom, Erdungswiderstand und Auslösepunkt der Fehlerstromschutzeinrichtung) ermöglicht. Des weiteren soll eine Vorrichtung zur Durchführung des erfindungsgemäßen Verfahrens angeboten werden.

Die Aufgabe wird, soweit sie das Verfahren betrifft, vom kennzeichnenden Teil des Patentanspruchs 1 gelöst. Vorteilhafte Ausführungsformen des erfindungsgemäßen Verfahrens werden durch die Unteransprüche 2 - 7 verwirklicht.

Hinsichtlich der Vorrichtung wird die Aufgabe durch den kennzeichnenden Teil des Patentanspruchs 8 gelöst. Vorteilhafte Ausführungsförmen der Vorrichtung werden durch die Unteransprüche 9 und 10 realisiert.

Das erfindungsgemäße Verfahren zur Überprüfung von Schutzmaßnahmen in realen IT-Netzen sieht die Verwendung eines Prüfgerätes vor, bei welchem - neben der üblichen Verbindung eines ersten Anschlusses mit einer der Netzphasen sowie der Verbindung eines zweiten Anschlusses an Schutzerde - ein dritter Sondenanschluß vorgesehen ist, der an ein neutrales Erdpotential angeschlossen wird. Dieses neutrale Erdpotential ist derart von der zu vermessenden Schutzerde des zweiten Anschlusses beabstandet, daß bei der Beaufschlagung der Schutzerde mit einem Fehlerstrom während der Prüfung und Messung des realen IT-Netzes keine Potentialveränderung des neutralen Erdpotentials auftritt. Durch Setzen des Sondenanschlusses außerhalb des Spannungstrichters der Schutzerde (in der Regel in einer Entfernung von mindestens 20m von der Schutzerdr) wird eine Beeinträchtigung des Sondenanschlusses von einer Potentialveränderung der Schutzerde ausgeschlossen.

Das erfindungsgemäße Verfahren sieht eine automatische Beendigung der Überprüfung des IT-Netzes vor, wenn durch das Prüfgerät festgestellt wird, daß der Sondenanschluß nicht ordnungsgemäß angeschlossen ist, eine Unterbrechung der Sondenleitung zwischen Prüfgerät und Sondenanschluß festgestellt wird, oder ein zu großer Sondenanschlußwiderstand (beispielsweise größer als 50 kOhm) ermittelt wird. Durch das erfindungsgemäße Verfahren wird somit die fehlerfreie Arbeitsweise des Sondenanschlusses des Prüfgerätes erkannt.

Nach dem geschilderten Anschluß des Prüfgerätes an eine der Phasen des IT-Netzes, an die Schutzerde sowie an das neutrale Erdpotential sieht das erfindungsgemäße Verfahren das Anlegen eines Fehlerstromes I_{P} zwischen der mindestens einen Phase des IT-Netzes und der Schutzerde vor, wodurch das Potential der Schutzerde um einen gewissen Betrag angehoben wird. Der angelegte Fehlerstrom I_{P} fließt im realen IT-Netz mit wie beschrieben angeschlossenem Prüfgerät von der durch das Prüfgerät angezapften Netzphase über das Prüfgerät in die Schutzerde und von der Schutzerde über Erde und die mit Erde in Verbindung stehenden Koppelimpedanz der angezapften Netzphase des realen IT-Netzes zurück in das IT-Netz und durch die Fehlerstromschutzeinrichtung(en).

Nun erfolgt im erfindungsgemäßen Verfahren eine Messung des Potentials der Schutzerde gegenüber dem neutralen Erdpotential (an welchem der Sondenanschluß angeschlossen ist). Das gemessene Potential wird überwacht. Falls ein vorgegebener Grenzwert (z.B. 25V oder 50V) überschritten werden, sieht das erfindungsgemäße Verfahren eine Abschaltung des Prüfstromes I_{P} und ein automatisches Beenden des Überprüfens des IT-Netzes innerhalb eines vorgebbaren Zeitintervalls vor. Diese automatische Beendigung des IT-Meßmodus erfolgt innerhalb der in der IEC 1010 geforderten Zeitintervalle.

Zur weiteren Verbesserung der Sicherheit des erfindungsgemäßen Verfahrens kann diese Potentialüberprüfung zwischen Sondenanschluß und Schutzerde auch bereits vor dem Anlegen des Fehlerstrom I_{P} durchgeführt werden und gegebenenfalls aus Sicherheitsgründen eine Abschaltung des Prüfgerätes sowie eine Beendigung des erfindungsgemäßen Verfahrens zur Überprüfung von IT-Netzen veranlaßt werden. Bei der Erfassung der Berührungsspannung durch das erfindungsgemäße Verfahren wird der während der Messung zwischen der Schutzerde und dem neutralen Erdpotential auftretende Spannungswert erfaßt.

Beim Stand der Technik wird demgegenüber wie beschrieben die Beruhungsspannung fälschlicherweise über die Erfassung des Potentials zwischen Schutzerde und angezapfter Netzphase erfaßt. Dieses konventionell erfaßte Potential ist jedoch wie beschrieben aufgrund der durch die Parallelschaltung des Prüfgerätes mit den Koppelimpedanzen des realen IT-Netzes aufgetretenen Netzspannungsveränderung verfälscht.

Das erfindungsgemäße Verfahren erlaubt somit eine zutreffende und unverfälschte Bestimmung der Berührungsspannung durch Erfassung des Potentials zwischen Schutzerde und dem neutralen Sondenanschluß.

Die zwischen den beschriebenen Punkten gemessene Berührungsspannung kann nun durch Anlegen eines Fehlerstroms I_{P} in Höhe des Nennfehlerstroms der zu prüfenden Fehlerstromschutzeinrichtung gemessen werden. Zur Vermeidung einer Netzbelastung kann die Berührungsspannung auch durch Anlegen eines Fehlerstroms I_{P} gemessen werden, der einem Teil des Nennfehlerstroms der Fehlerstromschutzeinrichtung entspricht und kann dann auf den tatsächlichen Wert der Berührungsspannung (bei einem Fehlerstrom in Höhe des Nennfehlerstroms) hochgerechnet werden.

Das erfindungsgemäße Verfahren sieht desweiteren die Möglichkeit vor, den fließenden Fehlerstrom I_{P} mit einem Sollwert zu vergleichen. Dieser Sollwert kann beispielsweise dem Nennfehlerstrom entsprechen, bei welchem die im zu überprüfenden realen IT-Netz verwendete Fehlerstromschutzeinrichtung anspricht. Falls der während der Messung und Prüfung fließende Konstantstrom diesen Sollwert nicht erreicht (beispielsweise aufgrund zu hoher Koppelimpedanzen der einzelnen Phasen des realen IT-Netzes gegenüber Erde) kann somit erkannt werden, daß die eingesetzten Fehlerstromschutzeinrichtungen einen überhöhten Nennfehlerstrom besitzen und somit zur Absicherung des überprüften realen IT-Netzes nicht geeignet sind.

Der Erdungswiderstand kann durch das erfindungsgemäße Verfahren nach Abschluß der Messung einfach aus der ermittelten Berührungsspannung und dem angelegten Konstantfehlerstrom nach dem Ohm'schen Gesetz berechnet werden.
Die erfindungsgemäße Vorrichtung zur Durchführung des geschilderten erfindungsgemäßen Verfahrens zeichnet sich durch eine automatische Abschaltvorrichtung zum Abschalten des Verfahrens zur Überprüfung des IT-Netzes aus. Diese automatische Abschaltvorrichtung spricht beim Nichtvorliegen eines ordnungsgemäßen Anschlusses der Sonde am neutralen Erdpotential automatisch an.

Desweiteren weist die erfindungsgemäß Vorrichtung eine automatische Abschaltvorrichtung zur Unterbrechung des angelegten Fehlerstromes I_{P} auf, welche bei Überschreitung eines vorgebbaren Grenzwertes des Potentialunterschiedes zwischen dem neutralen Erdpotential und der Schutzerde des IT-Netzes aus Sicherheitsgründen anspricht.

Ein Rechner der erfindungsgemäßen Vorrichtung bestimmt durch Anwendung des Ohm'schen Gesetzes den Erdungswiderstand Re aus der Berührungsspannung und dem angelegten Konstantstrom. Der ermittelte Widerstandswert für den Erdungswiderstand Re wird dann über eine am Prüfgerät vorgesehene Anzeigevorrichtung angezeigt.

Die Erfindung ist anhand von Ausführungsbeispielen in den Zeichnungsfiguren näher erläutert. Diese zeigen:
- Fig. 1: eine Darstellung eines realen IT-Netzes mit angeschlossenem Prüfgerät,
- Fig. 2: ein Flußdiagramm zur Darstellung der Verfahrensschritte bei der Auslöseprüfüng von Fehlerstromschutzeinrichtungen in IT-Netzen sowie
- Fig. 3: ein Flußdiagramm zur Darstellung der Verfahrensschritte zur Messung der Berührungsspannung in IT-Netzen.

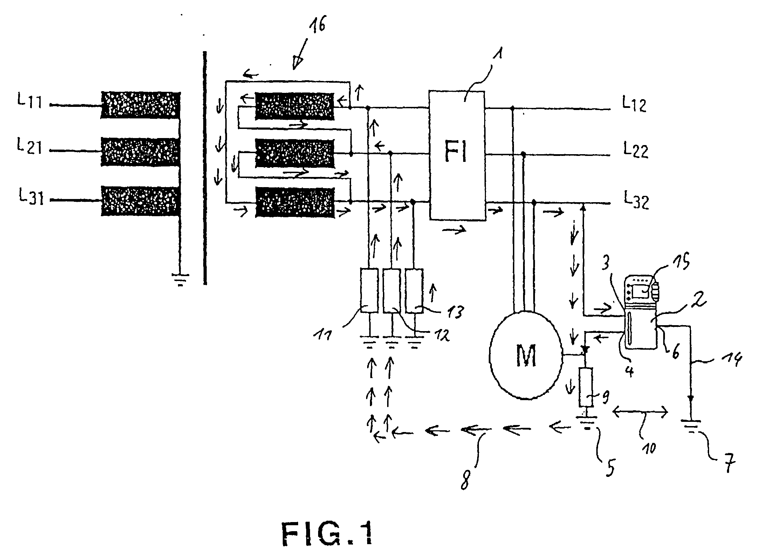

Fig. 1 zeigt ein reales IT-Netz mit den Netzphasen L₁₂, L₂₂ und L₃₂, welche durch Koppelimpedanzen 11, 12 und 13 relativ hochohmig geerdet sind. Das reale IT-Netz nach Fig. 1 weist ansonsten nichtgeerdete aktive Teile 16 auf sowie einen beispielhaften und geerdeten Verbraucher M. Die (unterschiedlichen) Koppelimpedanzen 11, 12 und 13 symbolisieren die im realen IT-Netz auftretende kapazitive Kopplung der einzelnen Netzphasen L₁₂, L₂₂ und L₃₂ gegenüber Erde. Zur Überprüfung der Fehlerstromschutzeinrichtung 1 sowie zur Erfassung von mit der Sicherheit des realen IT-Netzes in Zusammenhang stehenden Meßgrößen wird nun ein Meßgerät 2 mit einem ersten Anschluß 3, einem zweiten Anschluß 4 und einem dritten Sondenanschluß 6 dergestalt an das realen IT-Netz angeschlossen, daß der erste Anschluß 3 mit einer Netzphase (im vorliegenden Fall mit der Netzphase L₃₂) des IT-Netzes verbunden wird, der zweite Anschluß 4 mit einer Schutzerde 5 des IT-Netzes verbunden wird sowie der dritte Sondenanschluß 6 über eine Sondenleitung 14 mit neutralem Erdpotential 7 verbunden ist. Das neutrale Erdpotential 7 befindet sich in einem Abstand 10 (mindestens 20m) von der Schutzerde 5 entfernt und liegt somit außerhalb des Spannungstrichters der Schutzerde 5. Damit werden Potentialveränderungen der Schutzerde 5 im Rahmen der Prüfung mit dem Prüfgerät 2 am neutralen Erdpotential 7 nicht mehr erfasst.

Beim Aktivieren der Konstantstromquelle des Prüfgerätes 2 fließt nun ein zu messender Fehlerstrom I_{P} in Pfeilrichtung 8 über Prüfgerät 2, Erdungswiderstand 9, Schutzerde 5, Koppelimpedanzen 11, 12 sowie Fehlerstromschutzeinrichtung 1 und aktive Teile 16 (Aufteilung je nach Drehstromphasenlage).

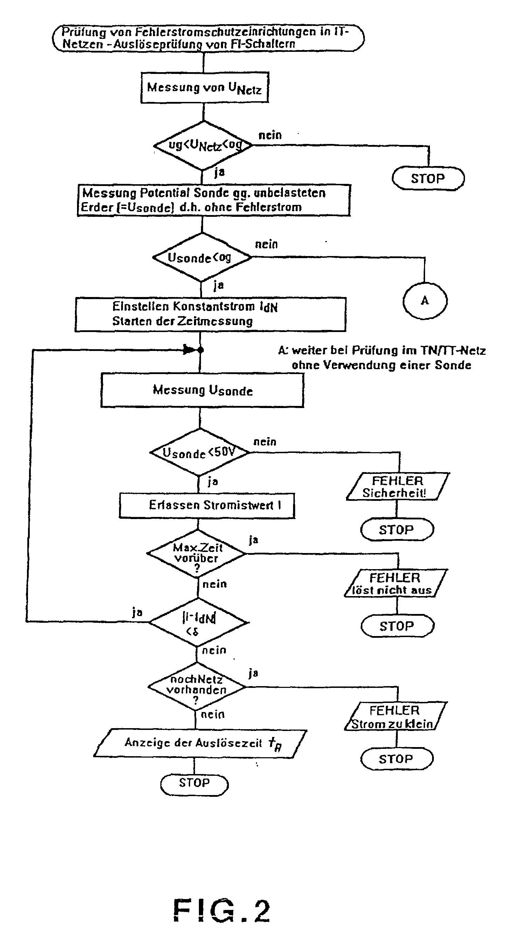

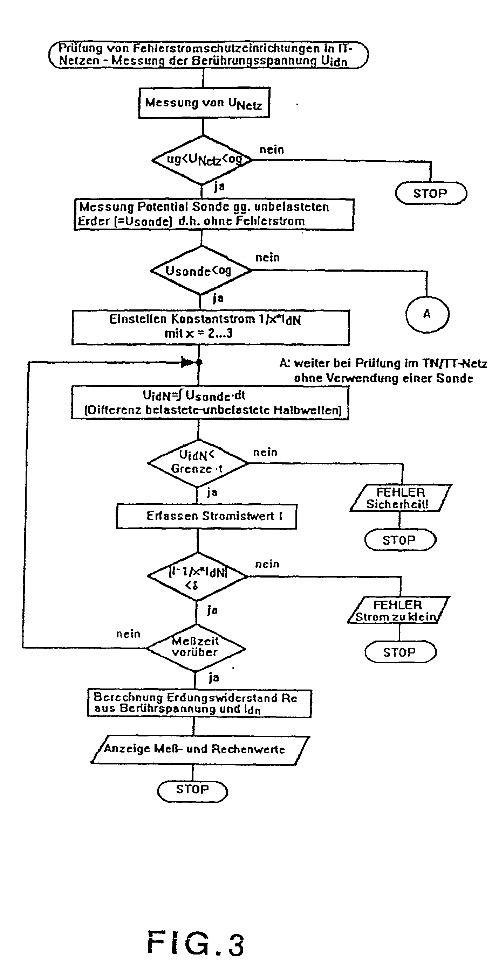

Zur Erläuterung der Verfahrensschritte des erfindungsgemäßen Verfahrens dienen die Flußdiagramme nach Fig. 2 und 3.

Das Flußdiagramm nach Fig. 2 zur Auslöseprüfung von Fehlerstromschutzeinrichtungen (bzw. FI-Schaltern) geht von einem Meßaufbau nach Fig. 1 aus und mißt zunächst die Netzspannung U_{Netz}. Falls diese zwischen einer zulässigen Untergrenze ug bzw. Obergrenze og liegt, wird das Potential zwischen dem neutralen Erdpotential 7 gegenüber der Schutzerde 5 ohne Fehlerstromeinspeisung durch das Prüfgerät 2 gemessen. Falls die gemessene Sondenspannung U_{Sonde} die Obergrenze og überschreitet, muß die weitere Prüfung des vorliegenden Netzes wie im TN-/TT-Netzes ohne Verwendung des dritten Sondenanschlusses 6 des Prüfgerätes 2 durchgeführt werden. Durch diesen Verfahrensschritt wird festgestellt, ob ein reales IT-Netz vorliegt.

Falls die Sondenspannung U_{Sonde} die vorgegebene Obergrenze og nicht überschreitet, wird davon ausgegangen, daß ein reales IT-Netz vorliegt und es wird über das Prüfgerät 2 ein Konstantstrom I_{dN} in das Netz eingespeist, so daß ein Fehlerstrom in Flußrichtung 8 (vgl. Fig. 1) fließt. Nun wird die Sondenspannung U_{Sonde} im belasteten Zustand (d. h. mit Fehlerstrom I_{P}) vorgenommen und es wird geprüft, ob die Sondenspannung U_{Sonde} (zwischen neutralem Erdpotential und Schutzerde 5) einen vorgebbaren Grenzwert (hier 50V) überschreitet. In diesem Fall wird die Netzüberprüfung aus Sicherheitsgründen sofort abgebrochen.

Falls die Sondenspannung U_{Sonde} den vorgegebenen Grenzwert nicht überschreitet, wird durch das Prüfgerät 2 der in Flußrichtung 8 fließende Ist-Strom mit dem Stromistwert I erfasst. Da der Konstantstrom I_{dN} die Höhe des Nennfehlerstroms besitzt, ist bei Überschreitung einer bestimmten Meßzeit eine Auslösung der Fehlerstromschutzeinrichtung 1 zu erwarten. Falls dies nicht geschieht wurde somit festgestellt, daß die Fehlerstromschutzeinrichtung 1 fehlerbehaftet ist.

Während der Meßzeit wird laufend der Betrag der Differenz zwischen Stromistwert I und Konstantstrom I_{dN} gebildet und wird festgestellt, ob diese Differenz einen Grenzwert überschreitet.

Wenn dies der Fall ist - wenn also der Stromistwert I den am Prüfgerät 2 eingestellten Konstantstrom I_{dN} übersteigt - wird geprüft, ob noch ausreichende Netzspannung im realen IT-Netz vorhanden ist.

Falls dies trotz des über die Schutzerde 5 und die Koppelimpedanz 13 hergestellten Erdschlusses der Fall ist, muß daraus geschlossen werden, daß die zu überprüfende Fehlerstromschutzeinrichtung 1 wirkungslos bleibt, da im vorliegenden realen IT-Netz trotz hergestelltem Erdschluß kein ausreichender Fehlerstrom I_{P} entstehen kann.

Wenn aber der Fehlerstrom IP ausgereicht hat, um die zu überprüfende Fehlerstromschutzeinrichtung 1 ansprechen zu lassen, wird durch das Prüfgerät 2 die Auslösezeit t_{A} erfasst und angezeigt.

Figur 3 zeigt das erfindungsgemäße Verfahren zur Messung der Berührungsspannung U_{idN} mit einem Meßaufbau nach Fig. 1. Zunächst wird wie beim Ablauf nach Fig. 2 U_{Netz} gemessen, mit der Untergrenze ug sowie der Obergrenze og verglichen, sowie die Spannung zwischen dem neutralen Erdpotential 7 und der unbelasteten Schutzerde 5 aufgenommen. Falls diese Spannung wiederum einen sicherheitsgefährdenden oberen Grenzwert og nicht überschreitet, wird nun nach Fig. 2 ein Bruchteil des Konstantstroms (z.B. die Hälfte, ein Drittel, usw.) am Prüfgerät 2 eingestellt und in Flußrichtung 8 nach Fig. 1 in Analogie zum entsprechenden Verfahrensschritt nach Fig. 2 ins reale IT-Netz eingespeist.

Dann wird die Berührungsspannung U_{idN} durch Aufintegration der Sondenspannung U_{Sonde} zwischen neutralem Erdpotential 7 und Schutzerde 5 über die Zeit erfasst. Falls die Berührungsspannung U_{idN} einen Grenzwert überschreitet, wird das Meßverfahren aus Sicherheitsgründen sofort abgebrochen. Andernfalls wird wie beim Verfahren nach Fig. 2 der Stromistwert I erfaßt, und eine betragsmäßige Differenz zwischen Stromistwert I und dem halbierten, gedrittelten, usw. eingespeisten Konstantstrom I_{dN} gebildet. Falls diese betragsweise Differenz einen Grenzwert δ nicht überschreitet und die Meßzeit vorüber ist, kann aus der ermittelten Berührungsspannung U_{idN} und dem eingestellten Konstantstrom I_{dN} der Erdungswiderstand Re berechnet und angezeigt werden.

Die Aufintegration der Berührungsspannung U_{idN} erfolgt bis zum Ende der Meßzeit.

Die Prüfung nach Fig. 3 wird ebenso wie die Prüfung nach Fig. 2 abgebrochen, wenn festgestellt wird, daß trotz vorhandenem Erdschluß (beispielsweise aufgrund zu hoher Koppelimpedanz 11, 12, 13) ein zu geringer Fehlerschlußstrom zur Auslösung (der damit überdimensionierten und wirkungslosen) Fehlerstromschutzeinrichtung 1 fließt.

### BEZUGSZEICHEN

- 1: Fehlerstromschutzeinrichtung
- 2: Prüfgerät
- 3: erster Anschluß
- 4: zweiter Anschluß
- 5: Schutzerde
- 6: dritter Sondenanschluß
- 7: neutrales Erdpotential
- 8: Flußrichtung des Fehlerstroms I_{P}
- 9: Erdungswiderstand Rₑ
- 10: Abstand
- 11,12,13: Koppelimpedanz
- 14: Sondenleitung
- 15: Anzeigevorrichtung
- 16: aktive Teile
- U_{Netz}: Netzspannung
- ug: Untergrenze
- og: Obergrenze
- U_{Sonde}: Sondenspannung
- U_{idN}: Berührungsspannung
- I: Stromistwert
- I_{P}: Fehlerstrom
- IdN: Konstantstrom
- δ: Grenzwert
- Rₑ: Erdungswiderstand
- t_{A}: Auslösezeit
- M: Verbraucher
- L₁₂, L₂₂ und L₃₂: Netzphasen des realen IT-Netzes

## Patentansprüche

1. Verfahren zur Überprüfung von Schutzmaßnahmen in mit Fehlerstromschutzeinrichtungen ausgestatteten realen IT-Netzen,
**gekennzeichnet durch**
**den Ablauf der folgenden Verfahrensschritte:**
a) Vorsehen eines Prüfgerätes (2), das in an sich bekannter Weise mit einem ersten Anschluß (3) an mindestens eine der Phasen eines IT-Netzes, mit einem zweiten Anschluß (4) an Schutzerde (5) und mit einem dritten Sondenanschluß (6) an ein neutrales Erdpotential (7) angeschlossen wird, welches derart von einer zu vermessenden Schutzerde (5) beabstandet ist, daß es nicht von der Potentialveränderung der Schutzerde (5) bei Beaufschlagung mit einem Fehlerstrom I_{P} während der Prüfung und Messung beeinträchtigt wird,
b) automatisches Beenden des IT-Meßmodus des Prüfgerätes bei Auftreten eines der nachfolgenden Zustände:
ba) Feststellung, daß der Sondenanschluß (6) nicht ordnungsgemäß angeschlossen ist,
bb) Feststellung einer Unterbrechung der Sondenleitung (14) zwischen Prüfgerät (2) und Sondenanschluß (6),
bc) Feststellung eines zu großen Sondenanschlußwiderstandes,
c) Anlegen eines Fehlerstromes I_{P} zwischen der mindestens einen Phase und der Schutzerde (5), wodurch das Potential der Schutzerde (5) um einen gewissen Betrag angehoben wird,
d) Messung des Potentials der Schutzerde (5) gegenüber dem neutralen Erdpotential (7) und Überwachung des Potentials der Schutzerde (5) auf Überschreiten eines vorgebbaren Grenzwertes, z.B. 25 V oder 50 V, sowie
e) automatisches Beenden des IT-Meßmodus des Prüfgerätes (2) unter Abschaltung des Prüfstromes I_{P} innerhalb eines vorgebbaren Zeitintervalls bei Überschreiten des Grenzwertes gemäß Verfahrensschritt d).

2. Verfahren nach Anspruch 1,
**dadurch gekennzeichnet,**
**daß** vor dem Anlegen des Fehlerstromes I_{P} gemäß Merkmal c) in Anspruch 1 eine Potentialüberprüfung zwischen Sondenanschluß (6) und vom Prüfstrom I_{P} unbelasteten Schutzerde (5) durchgeführt wird und bei Überschreiten einer vorgebbaren Schwelle der IT-Meßmodus des Prüfgerätes (2) automatisch abgeschaltet wird.

3. Verfahren nach einem der vorhergehenden Ansprüche 1 oder 2,
**dadurch gekennzeichnet,**
**daß** der während der Messung auftretende Spannungswert zwischen der Schutzerde (5) und dem neutralen Erdpotential (7) als Berührungsspannung U_{idN} definiert und erfaßt wird.

4. Verfahren nach Anspruch 3,
**dadurch gekennzeichnet,**
**daß** die Berührungsspannung U_{idN} bei Nennfehlerstrom der Fehlerstromschutzeinrichtung (2) gemessen wird.

5. Verfahren nach Anspruch 3,
**dadurch gekennzeichnet,**
**daß** die Berührungsspannung U_{idN} bei einem Teil des Nennfehlerstromes der Fehlerstromschutzeinrichtung (2) gemessen und auf Nennfehlerstrom hochgerechnet wird.

6. Verfahren nach einem der vorhergehenden Ansprüche,
**dadurch gekennzeichnet,**
**daß** der Fehlerstrom I_{P} während der Messung und Prüfung als Konstantstrom I_{dN} angelegt und auf Übereinstimmung mit einem Sollwert hin überwacht wird.

7. Verfahren nach Anspruch 6,
**dadurch gekennzeichnet,**
**daß** nach Abschluß der Messung der Erdungswiderstand (9) aus der Berührungsspannung U_{idN} und dem Konstantstrom I_{dN} berechnet wird.

8. Vorrichtung zur Durchführung des Verfahrens nach einem der vorhergehenden Ansprüche mit einem Prüfgerät (2), das mittels eines ersten Anschlusses (3) an eine Phase eines IT-Netzes anschließbar ist, mit einem zweiten Anschluß (4) an Schutzerde (5) des IT-Netzes anschließbar ist und das eine Konstantstromquelle zur Erzeugung eines Fehlerstromes (I_{B}) aus mindestens einer der Phasen sowie einen Sondenanschluß (6) aufweist, an den eine in neutralem Erdpotential (7) befindliche Sonde anschließbar ist, wobei das Prüfgerät (2) eine Meßvorrichtung aufweist, die zur Erfassung des Potentialunterschiedes zwischen dem neutralen Erdpotential (7) und der Schutzerde (5) dient,
**dadurch gekennzeichnet, daß**
daß die Vorrichtung eine automatische Abschaltvorrichtung zum Abschalten des manuell einstellbaren IT-Meßmodus aufweist, die nach Durchführung einer Spannungs- und Widerstandsmessung zwischen dem Sondenanschluß (6) und der Schutzerde (5) den ordnungsgemäßen Anschluß des Sondenanschlusses (6) überprüft und bei Nichtvorliegen eines solchen ordnungsgemäßen Anschlusses den IT-Modus automatisch verläßt.

9. Vorrichtung nach Anspruch 8,
**dadurch gekennzeichnet,**
**daß** eine weitere automatische Abschaltvorrichtung zur Unterbrechung des Fehlerstromes I_{P} vorgesehen ist, die bei Überschreitung eines vorgebbaren Grenzwertes des Potentialunterschiedes zwischen dem neutralen Erdpotential und der Schutzerde (5) des IT-Netzes anspricht.

10. Vorrichtung nach einem der Ansprüche 8 und 9,
**dadurch gekennzeichnet,**
**daß** das Prüfgerät (2) einen Rechner aufweist, der den Erdungswiderstand (9) aus der Berührungsspannung U_{idN} und dem Konstantstrom I_{dN} berechnet und über eine am Prüfgerät (2) vorgesehene Anzeigevorrichtung (15) anzeigt.

## Claims

1. Method for checking protective measures in actual IT networks which are equipped with fault current protective devices,
**characterized by**
**the sequence of the following method steps:**
a) provision of a test set (2) which is connected in a manner known per se by means of a first connection (3) to at least one of the phases of an IT network, by means of a second connection (4) to a protective earth (5) and by means of a third probe connection (6) to a neutral earth potential (7) which is separated from a protective earth (5) (which is to be measured) such that it is not adversely affected by the potential change at the protective earth (5) when a fault current I_{P} is applied during testing and measurement,
b) automatic ending of the IT measurement mode of the test set when one of the following situations occurs:
ba) it is found that the probe connection (6) is not connected correctly,
bb) an interruption is found in the probe line (14) between the test set (2) and the probe connection (6),
bc) an excessively high probe connection resistance is found,
c) application of a fault current I_{P} between the at least one phase and the protective earth (5), which results in the potential at the protective earth (5) being increased by a certain amount,
d) measurement of the potential at the protective earth (5) with respect to the neutral earth potential (7), and monitoring of the potential at the protective earth (5) to check that a limit value, for example 25 V or 50 V which can be preset, is not exceeded, and
e) automatic ending of the IT measurement mode of the test set (2), with the test current I_{P} being switched off within a time interval which can be predetermined, if the limit value in method step d) is exceeded.

2. Method according to Claim 1,
**characterized**
**in that**, before the fault current I_{P} is applied in accordance with feature c) in Claim 1, a potential check is carried out between the probe connection (6) and the protective earth (5) without any test current I_{P} being applied, if a threshold which can be predetermined is exceeded, the IT measurement mode of the test set (2) is automatically switched off.

3. Method according to one of the preceding Claims 1 or 2,
**characterized**
**in that**, the voltage value which occurs during the measurement between the protective earth (5) and the neutral earth potential (7) is defined as a contact voltage U_{idN}, and is recorded.

4. Method according to Claim 3,
**characterized**
**in that**, the contact voltage U_{idN} is measured with the rated fault current flowing through the fault current protective device (2).

5. Method according to Claim 3,
**characterized**
**in that**, the contact voltage U_{idN} is measured when a fraction of the rated fault current is flowing through the fault current protective device (2), and is converted for the rated fault current.

6. Method according to one of the preceding claims,
**characterized**
**in that**, the fault current I_{P} is applied as a constant current I_{dN} during the measurement and test, and is monitored to ensure that it matches a nominal value.

7. Method according to Claim 6,
**characterized**
**in that**, once the measurement has been completed, the earthing resistance (9) is calculated from the contact voltage U_{idN} and the constant current I_{dN}.

8. Apparatus for carrying out the method according to one of the preceding claims using a test set (2) which can be connected by means of a first connection (3) to one phase of an IT network, can be connected by means of a second connection (4) to a protective earth (5) of the IT network, and which has a constant current source for producing a fault current (I_{B}) from at least one of the phases and has a probe connection (6) to which a probe, which is at the neutral earth potential (7) can be connected, with the test set (2) having a measurement apparatus which is used for detecting the potential difference between the neutral earth potential (7) and the protective earth (5),
**characterized in that**,
the apparatus has an automatic switching-off apparatus for switching off the manually adjustable IT measurement mode, which switching-off apparatus checks that the probe connection (6) is connected correctly and automatically leaves the IT mode if such a correct connection does not exist, after carrying out a voltage and resistance measurement between the probe connection (6) and the protective earth (5).

9. Apparatus according to Claim 8,
**characterized**
**in that**, a further automatic switching-off apparatus is provided for interrupting the fault current I_{P} and responds if a limit value, which can be predetermined, is exceeded for the potential difference between the neutral earth potential and the protective earth (5) of the IT network.

10. Apparatus according to one of Claims 8 and 9,
**characterized**
**in that**, the test set (2) has a computer, which calculates the earthing resistance (9) from the contact voltage U_{idN} and the constant current I_{dN}, and indicates the earthing resistance (9) via a display apparatus (15) which is provided on the test set (2).

## Revendications

1. Procédé de vérification des mesures de protection dans des réseaux réels réalisés selon le schéma IT équipés de dispositifs de protection à courant différentiel résiduel,
**caractérisé par le déroulement des étapes suivantes :**
a) prévision d'un appareil de test (2) raccordé d'une manière connue par une première connexion (3) à au moins une des phases d'un réseau selon schéma IT, par une deuxième connexion (4) à la terre de protection (5) et par une troisième connexion de sonde (6) à un potentiel de terre neutre (7), lequel est espacé d'une terre de protection (5) à mesurer d'une manière telle qu'il n'est pas affecté par la variation de potentiel de la terre de protection (5) lorsqu'il est soumis à un courant différentiel résiduel Iₚ pendant le test et la mesure,
b) arrêt automatique du mode de mesure IT de l'appareil de test en cas de survenue d'un des états suivants :
ba) détection d'un raccordement défectueux de la connexion de sonde (6),
bb) détection d'une coupure de la ligne de sonde (14) entre appareil de test (2) et connexion de sonde (6),
bc) détection d'une trop grande résistance de la connexion de sonde,
c) application d'un courant différentiel résiduel Iₚ entre au moins une phase et la terre de protection (5), suite à quoi le potentiel de la terre de protection (5) s'élève d'une certaine valeur,
d) mesure du potentiel de la terre de protection (5) par rapport au potentiel de terre neutre (7) et contrôle du potentiel de la terre de protection (5) quant au dépassement d'une valeur limite définissable, p. ex. 25 V ou 50 V, ainsi que
e) arrêt automatique du mode de mesure IT de l'appareil de test (2) par coupure du courant d'essai Iₚ au sein d'un intervalle de temps définissable en cas de dépassement de la valeur limite mentionnée à l'étape de procédé d).

2. Procédé selon la revendication 1,
**caractérisé par le fait**
**qu'**il est effectué, avant l'application du courant différentiel résiduel Iₚ, selon caractéristique c) de la revendication 1, une vérification du potentiel entre la connexion de sonde (6) et la terre de protection (5) non soumise au courant d'essai Iₚ et qu'une coupure automatique intervient en cas de dépassement d'un seuil définissable du mode de mesure IT de l'appareil de test (2).

3. Procédé selon l'une des revendications 1 ou 2 précédentes,
**caractérisé par le fait**
**que** la valeur de tension apparaissant pendant la mesure entre la terre de protection (5) et le potentiel de terre neutre (7) est définie et saisie en tant que tension de contact U_{idN}.

4. Procédé selon la revendication 3,
**caractérisé par le fait**
**que** la tension de contact U_{idN} est mesurée avec le courant différentiel résiduel nominal du dispositif de protection à courant différentiel résiduel (2).

5. Procédé selon la revendication 3,
**caractérisé par le fait**
**que** la tension de contact U_{idN} est mesurée avec une partie du courant différentiel résiduel nominal du dispositif de protection à courant différentiel résiduel (2) et extrapolée pour le courant différentiel résiduel nominal.

6. Procédé selon l'une des revendications précédentes,
**caractérisé par le fait**
**que** le courant différentiel résiduel Iₚ est appliqué pendant la mesure et le test sous forme de courant constant I_{dN} et contrôlé quant à sa coïncidence avec une valeur de consigne.

7. Procédé selon la revendication 6,
**caractérisé par le fait**
**qu'**une fois la mesure terminée, la résistance de terre (9) se calcule à partir de la tension de contact U_{idN} et du courant constant I_{dN}.

8. Dispositif de mise en application du procédé conforme à l'une des revendications précédentes à l'aide d'un appareil de test (2) raccordable au moyen d'une première connexion (3) à une phase d'un réseau selon schéma IT, par une deuxième connexion (4), à la terre de protection (5) du réseau selon schéma IT et présentant une source de courant constant permettant de générer un courant différentiel résiduel (I_{B}) provenant d'au moins une des phases ainsi qu'une connexion de sonde (6) à laquelle peut être raccordée une sonde se trouvant à un potentiel de terre neutre (7), l'appareil de test (2) présentant un dispositif de mesure servant à saisir la différence de potentiel entre le potentiel de terre neutre (7) et la terre de protection (5),
**caractérisé par le fait**
**que** le dispositif présente un dispositif de coupure automatique pour la coupure du mode de mesure IT réglable manuellement, qui, après exécution d'une mesure de tension et de résistance entre la connexion de sonde (6) et la terre de protection (5), vérifie le raccordement correct de la connexion de sonde (6) et, en l'absence de raccordement correct, quitte automatiquement le mode de mesure IT.

9. Dispositif selon la revendication 8,
**caractérisé par le fait**
**qu'**il est prévu un autre dispositif de coupure automatique pour interrompre le courant différentiel résiduel Iₚ, qui se déclenche en cas de dépassement d'une valeur limite définissable de la différence de potentiel entre le potentiel de terre neutre et la terre de protection (5) du réseau selon schéma IT.

10. Dispositif selon l'une des revendications 8 et 9,
**caractérisé par le fait**
**que** l'appareil de test (2) présente un calculateur qui calcule la résistance de terre (9) à partir de la tension de contact U_{idN} et du courant constant I_{dN} et l'affiche au moyen d'un dispositif d'affichage (15) prévu sur l'appareil de test (2).
